Europäisches Patentamt

European Patent Office

Office européen des brevets

(11) Publication number: **0 333 151 B1**

## EUROPEAN PATENT SPECIFICATION

(45) Date of publication of patent specification: **20.10.93**  (51) Int. Cl.⁵: **H01L 29/78**, G02F 1/133

(21) Application number: **89104568.4**

(22) Date of filing: **15.03.89**

(54) **Thin film transistor.**

(30) Priority: **18.03.88 JP 64960/88**
**24.03.88 JP 69988/88**

(43) Date of publication of application:
**20.09.89 Bulletin 89/38**

(45) Publication of the grant of the patent:
**20.10.93 Bulletin 93/42**

(84) Designated Contracting States:
**DE FR GB**

(56) References cited:
**EP-A- 0 200 138**
**EP-A- 0 209 113**
**EP-A- 0 216 673**
**FR-A- 2 599 559**

**PATENT ABSTRACTS, vol. 10, no. 289**
**(E-442)[2345], 2nd October 1986; & JP-A-61**
**108 171 (TOSHIBA CORP.) 26-05-1986**

**JAPAN DISPLAY '86, pp. 196-199**

(73) Proprietor: **SEIKO EPSON CORPORATION**
**4-1, Nishishinjuku 2-chome**
**Shinjuku-ku Tokyo-to(JP)**

(72) Inventor: **Nakazawa, Takashi**
**c/o Seiko Epson Corporation**
**3-5, Owa 3-chome**
**Suwa-shi Nagano-ken(JP)**

(74) Representative: **Hoffmann, Eckart Patentan-**
**walt Blumbach & Partner et al**
**Bahnhofstrasse 103**
**D-82166 Gräfelfing (DE)**

## Description

The invention relates to thin film transistors applicable to liquid crystal displays of the active matrix type, to image sensors and three dimensional integrated circuits.

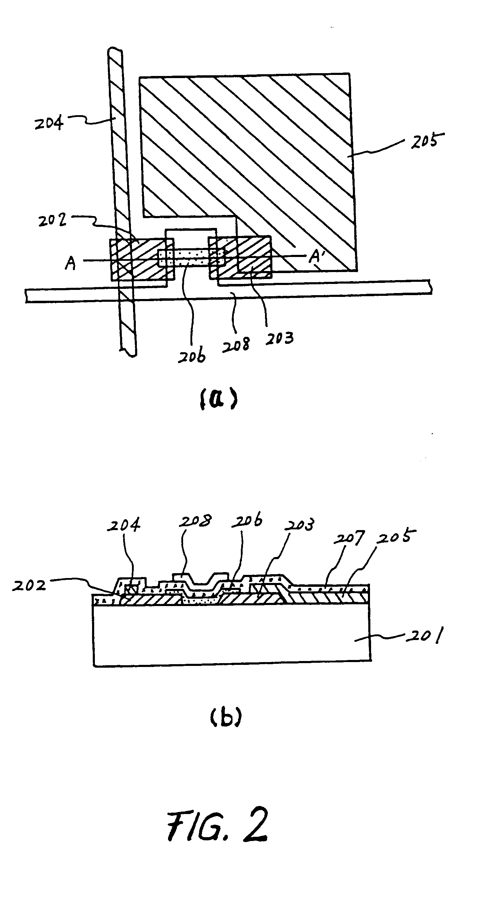

Conventionally, thin film transistors have a structure as disclosed in JAPAN DISPLAY '86, 1986, pp. 196-199. Fig. 2 shows a generalized outline of this structure, Fig. 2(a) being a top plan view and Fig. 2(b) a cross-sectional view along the line A-A' in Fig. 2(a).

On an insulating substrate 201 made of glass, quartz or sapphire are formed a source region 202 and a drain region 203, each comprising a polycrystalline silicon thin film doped with donor or acceptor type impurities. A source electrode 204 and a drain electrode 205 are disposed to contact source region 202 and drain region 203, respectively, and a channel region 206 made of a polycrystalline silicon thin film is arranged thereon to contact both regions on their respective upper side. These elements are covered by a gate insulating film 207. On the insulating film 207 a gate electrode 208 is formed.

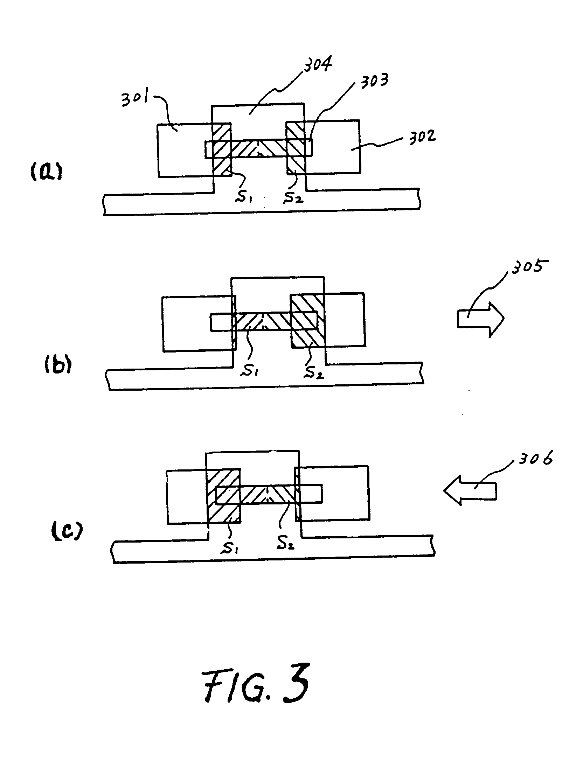

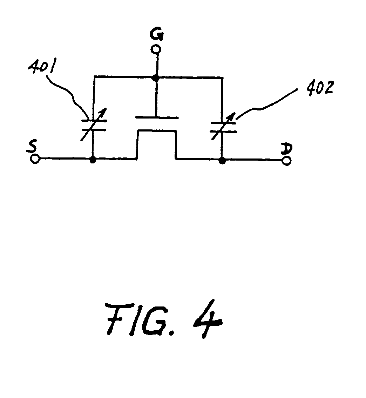

The described structure of conventional thin film transistors has disadvantages which will be explained with reference to Figs. 3 and 4.

Fig. 3 is a top plan view corresponding to a portion of Fig. 2(a), and Fig. 4 shows an equivalent circuit thereof.

As shown in Fig. 3(a) and Fig. 4, a parasitic capacitor 401 is formed between gate G and source S by the gate electrode 304 and the hatched portion S1 with the gate insulating film as a dielectric therebetween. Likewise, a parasitic capacitor 402 is formed between gate G and drain D by the gate electrode 304 and the hatched portion S2.

When the pattern of gate electrode 304 is slipped or displaced in the direction of arrow 305 with respect to the source region 301 and the drain region 302, as shown in Fig. 3(b), the capacitance of parasitic capacitor 401 is decreased while the capacitance of parasitic capacitor 402 is increased. Conversely, when the pattern of gate electrode 304 is displaced in the direction of arrow 306 as shown in Fig. 3(c), the capacitance of capacitor 401 is increased and that of capacitor 402 is decreased. The parasitic capacitance of the thin film transistor thus varies widely depending on the location of gate electrode 304 with respect to that of the source electrode 301 and the drain electrode 302. Main factors for such pattern displacement are an alignment error of gate electrode 304 and a pitch slippage between photo masks. Accordingly, the parasitic capacitance varies within the same substrate or between substrates, making it nearly impossible to keep the circuit constants at predetermined values and resulting in a display quality dispersion when such thin film transistors are applied to a liquid crystal display, thereby deteriorating the picture quality. Further, the pattern displacement becomes larger in a large-sized liquid crystal display and thus has been a big obstacle to making liquid crystal display devices larger, due to an extreme deterioration of the display quality.

For the same reason, when this conventional thin film transistor is applied to an image sensor or a three dimensional integrated circuit, it is difficult to maintain the circuit constants at predetermined values. This has been a big obstacle to the practical use.

*As an attempt to reduce the influence of such pattern displacements on the parasictic capacitance, the document FR-A-2 599 559 discloses a thin film transistor having in one embodiment source and drain electrodes and a gate electrode in the form of eloganted strips extending in parallel to each other. The dimensions of these parallel strips are such that a pattern displacement in one direction, namely perpendicular to the strips would not influence the parasitic capacitors. In another embodiment of this known thin film transistor source electrode strips and drain electrode strips extend perpendicularly and from opposite sides over a gate electrode. The source electrode strips and the drain electrode strips do not completely cross the gate electrode strip, so that a displacement error only in a direction perpendicular to the source and drain electrode strips would be uncritical.*

*The document EP-A-0 200 138 discloses a thin film transistor comprising a gate electrode, one or more drain electrodes connected to a picture electrode, and a source bus line which applies a voltage to one or more source electrodes connected thereto, wherein said one drain electrode is formed between said source bus line which functions by itself as a source electrode and said one source electrode connected to said source bus line or between said source electrodes adjacent to each other, the source bus line, the source electrode and the drain electrode being formed in parallel to each other and perpendicular to the gate electrode. With each drain electrode positioned between two source electrodes, in this transistor, the effective channel length is halved to increase the ratio of channel width to channel length.*

*The document EP-A-0 216 673 discloses a thin film transistor having a drain electrode in the form of an elongated strip extending in parallel to a source bus line, the arrangement of these two electrodes being perpendicularly*

*crossed by a gate line structure having a semiconductor layer, a gate insulating layer and an gate electrode layer.*

Accordingly it is an object of the present invention to remedy the above mentioned drawbacks of the prior art and to provide an improved thin film transistor whose parasitic capacitance is substantially not influenced by such pattern displacement.

This object is achieved with a thin film transistor as claimed in claim 1.

A specific embodiment of the invention is claimed in the dependent claim.

The present invention has the following advantageous effects:

First of all, the parasitic capacitance of the thin film transistor can be kept constant and unaffected by a pattern displacement. As a result, if thin film transistors according to the invention are employed for a liquid crystal display device, the individual source lines thereof will have the same constant capacitance. Thus, a liquid crystal display having a uniform display quality and a high picture quality over a large-sized picture without a variation of the delay time of a signal between individual source lines can be realized.

Secondly, the parasitic capacitance between the source electrode and the gate electrode of the thin film transistor can be reduced compared to that of a conventional thin film transistor. Therefore, when this transistor is used for a liquid crystal display device, the driving circuit load can be reduced so that inexpensive driver ICs with small-sized chips can be employed. If, on the other hand, a driver IC with a conventional relatively high driving capacity is used, a liquid crystal display device with a higher number of scanning lines can be driven.

Thirdly, since the parasitic capacitance between the drain electrode and the gate electrode is kept constant and unaffected by a pattern displacement and is reduced compared to the conventional thin film transistor, the holding characteristic of the signal voltage in the liquid crystal layer can be improved and a high quality picture of a high contrast ratio without flicker can be achieved.

Forthly, it becomes easier to design a circuit on an active matrix substrate and a hold circuit due to the circuit constant being kept at a certain level.

Fifthly, since the tolerance for a pattern displacement can be set at a comparatively large value, the strict process control required for the conventional thin film transistor can be released, thereby improving the production yield remarkably.

Sixthly, as the parasitic capacitance can be kept constant regardless of a pattern displacement, variations within one substrate or between substrates can be eliminated, thereby improving the quality remarkably. As a result, the thin film transistors can be used on large-sized substrates.

Seventhly, the characteristic of the thin film transistor according to the invention is entirely the same as that of a conventional one so that the small OFF current and the large ON current can be maintained.

Eighthly, if a semiconductor such as polycrystalline silicon, which is formed at a comparatively high temperature of 500°C and higher, is used for the semiconductor layer, the parasitic capacitance can be kept constant and unaffected by a pattern displacement due to a contraction of the substrate, thereby keeping a circuit constant at a predetermined level.

As described above, the thin film transistor constructed in accordance with the invention, has various excellent effects and can be applied to various fields, an active matrix substrate for display and the peripheral circuits thereof, an image sensor, a three dimensional integrated circuit or the like.

Ways of carrying out the invention will be described in detail below with reference to the drawings which show specific embodiments only and in which

Fig. 1(a)

is a top plan view of a thin film transistor according to the invention,

Fig. 1(b)

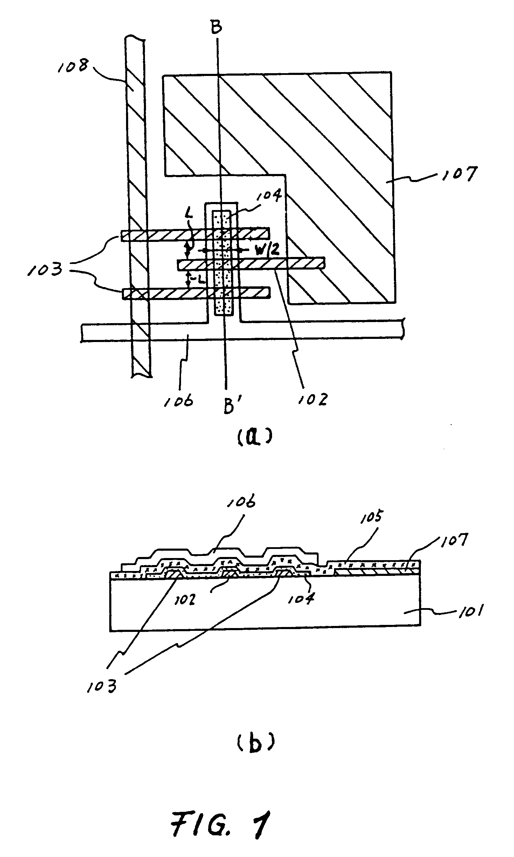

is a cross-sectional view along line B-B' of Fig. 1(a),

Fig. 2(a)

is a top plan view of a conventional thin film transistor,

Fig. 2(b)

is a cross-sectional view along line A-A' in Fig. 2(a),

Figs. 3(a) to (c)

are top plan views used for explaining problems with the conventional thin film transistor,

Fig. 4

is an equivalent circuit of the conventional thin film transistor,

Figs 5(a) to (e)

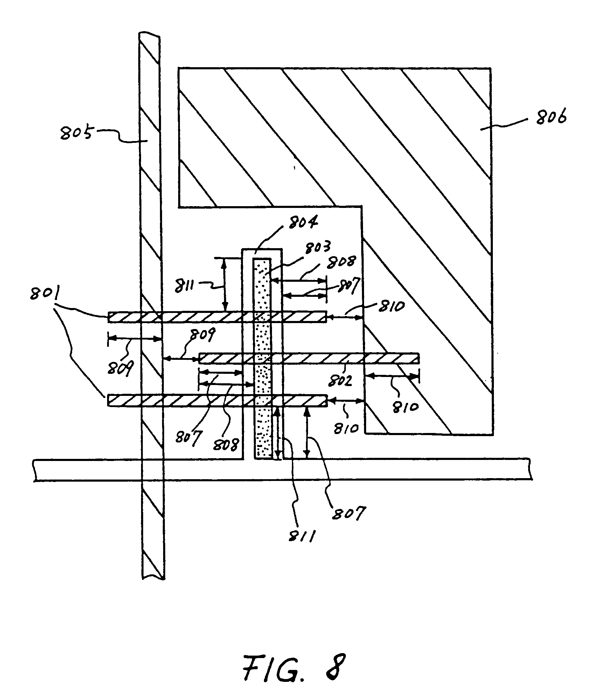

and Fig. 8 are top plan views of a thin film transistor according to the invention,

Fig. 6

is an equivalent circuit thereof,

Fig. 7

is a graph showing the contraction of a substrate,

Fig. 9(a) and (b)

are top plan views of a thin film transistor according to the invention and a conventional thin film transistor, respectively,

Fig. 10

is an equivalent circuit of a liquid crystal display device using thin film transistors,

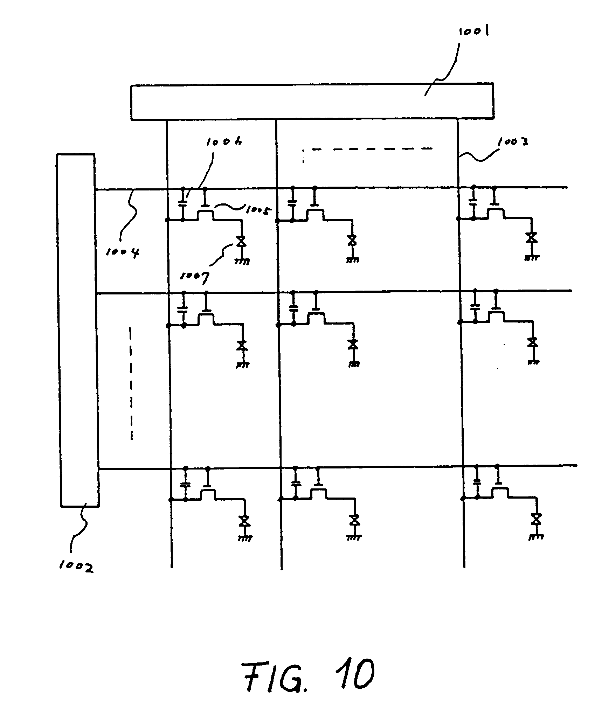

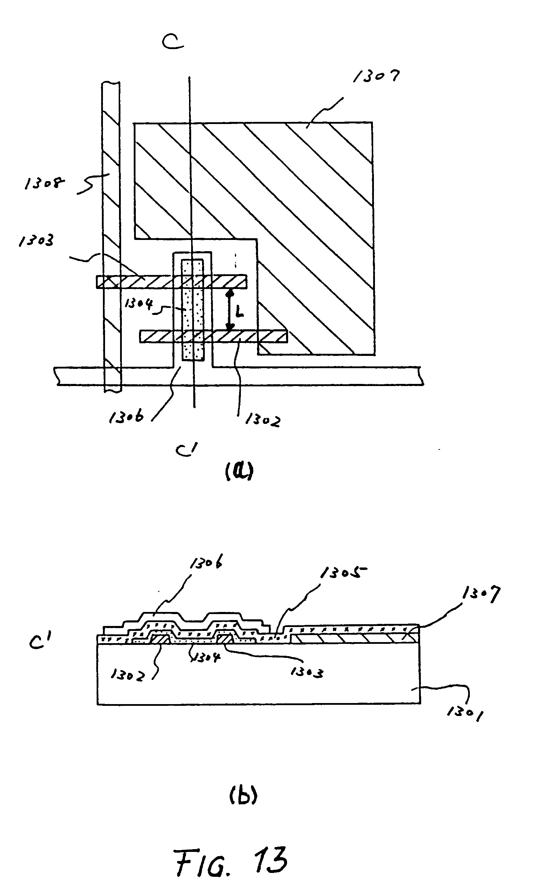

Figs. 11(a) to (c)
are driving waveforms of the liquid crystal display device of Fig. 10,
Fig. 12
is a graph showing electrical characteristics of the thin film transistor according to the invention,
Fig. 13(a)
is a top plan view of a thin film transistor according to another embodiment of the invention,
Fig. 13(b)
is a cross-sectional view along line C-C' of Fig. 13(a), and
Figs. 14(a) to (c)
are top plan views of a thin film transistor according to the invention.

The thin film transistor shown in Figs. 1(a) and (b) comprises two source electrodes 103 arranged in parallel with each other on an insulating substrate 101 made of glass, quartz, sapphire or the like. The two source electrodes 103 are made of silicon thin films such as polycrystalline silicon or amorphous silicon doped with donor or acceptor type impurities. A drain electrode 102 is arranged between the two source electrodes 103 in parallel therewith. A desired width of the source electrodes 103 and the drain electrode 102 is 20 $\mu$m or less and their thickness is preferably between 50 and 500 nm. A semiconductor layer 104 is formed on and between the source electrodes 103 and the drain electrode 102, contacting them on their respective upper side. The thickness of the semiconductor layer 104 is preferably 200 nm or less. A source line 108 made of metal or a transparent conductive film contacts the two source electrodes 103 and a drain line 107 similarly contacts the drain electrode 102. These elements are entirely covered with a gate insulating film 105 such as a $SiO_2$ or SiON (silicon oxy nitride) film. Semiconductor layer 104 is covered with a gate electrode 106 made of metal or a transparent conductive film with a gate insulating film 105 therebetween. Gate insulating film 105 also serves as an interlayer insulation.

A thus constructed thin film transistor is equivalent to a parallel circuit of two thin film transistors. The channel length of the thin film transistor is L (Fig. 1(a)) and the space between the two source electrodes 103 corresponds to twice the channel length L plus the line width of the drain electrode 102. The channel width W (Fig. 1(a)) corresponds to twice the width of semiconductor layer 104.

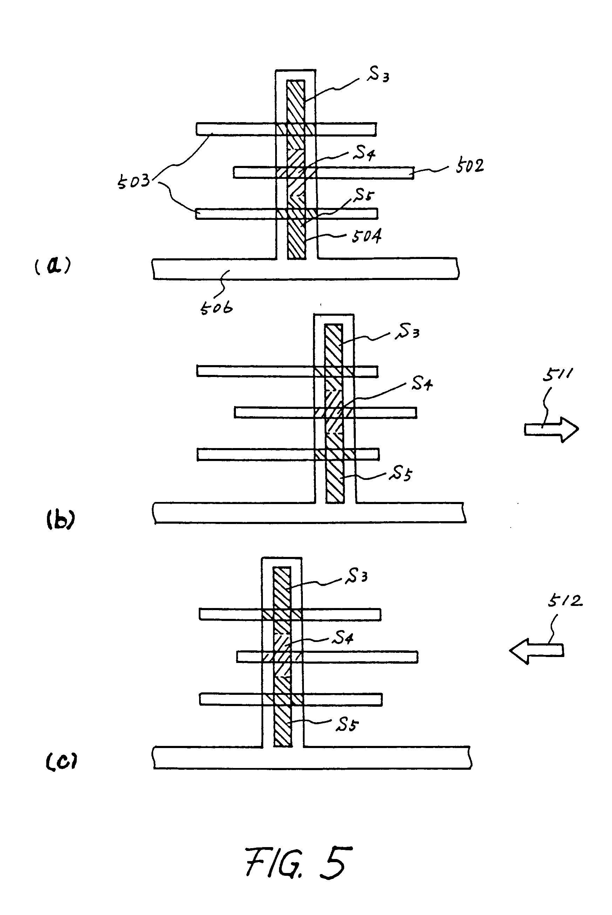

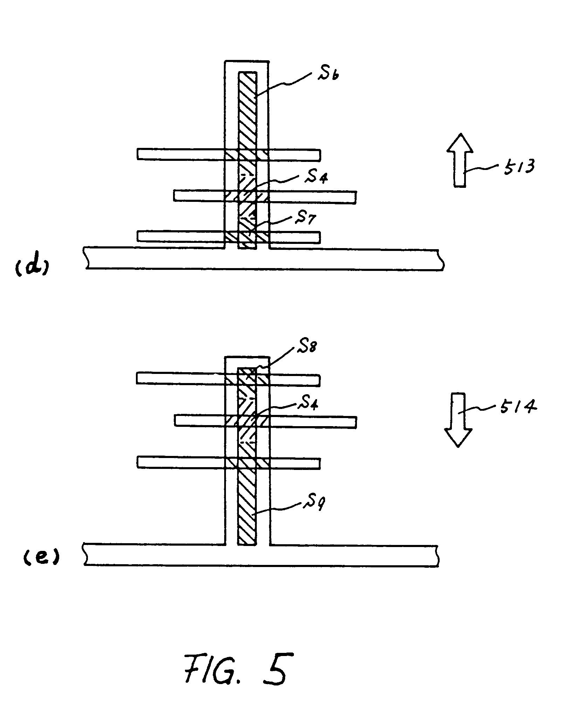

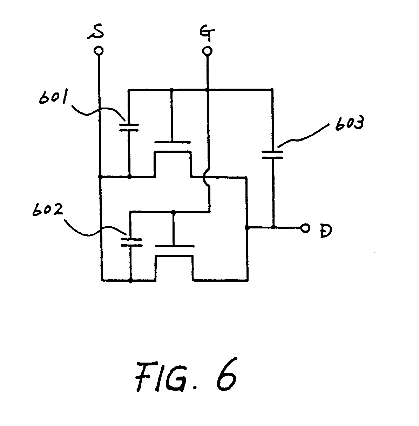

Fig. 5 are top plan views of this thin film transistor and Fig. 6 is an equivalent circuit thereof.

As shown in Fig. 5(a) and in Fig. 6, parasitic capacitors 601 and 602 are formed by the gate electrode 506 and the hatched portions S3 and S5 with the gate insulating film as dielectric, between gate G and source S in Fig. 6. Likewise, a parasitic capacitor 603 is formed by the gate electrode 506 and the hatched portion S4 between gate G and drain D. As shown in Fig. 5(b), when the pattern of the gate electrode 506 is shifted with respect to the source and drain electrodes in the direction of arrow 511, the areas S3, S4 and S5 are kept constant. This means that the capacitance of capacitors 601, 602 and 603 remains constant and unaffected by the pattern displacement. When the pattern of the gate electrode 506 is shifted in the direction of arrow 512 as shown in Fig. 5(c), the parasitic capacitances are kept constant in the same way. When the pattern of the gate electrode 506 is shifted in the direction of arrow 513 according to Fig. 5(d), while the area of portion S4 is not changed compared to the situation of Fig. 5(a), the areas of portions S3 and S5 are changed. Even if due to this change the capacitance of the parasitic capacitor 601 is increased and that of the parasitic capacitor 602 decreased, the total parasitic capacitance at the source side has the same value as in case of no pattern displacement (S6 + S7 = S3 + S5) due to the parallel connection of the parasitic capacitors 601 and 602 shown in the equivalent circuit of Fig. 6. A pattern shift in the direction of arrow 514 according to Fig. 5(e) has the same result, namely S8 + S9 = S3 + S5. As described above, the parasitic capacitance of the thin film transistor according to the invention remains constant, even if a pattern displacement is caused in any direction. Thus, a variation of parasitic capacitances on the same substrate or between different substrates can be eliminated.

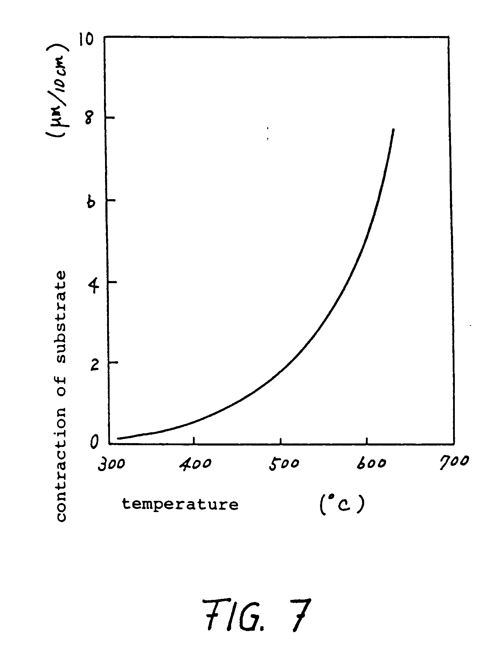

A glass substrate is widely used as the insulating substrate for thin film transistors. Generally, when a glass substrate is heat treated and then cooled to room temperature, the external dimension becomes smaller than that before the heat treatment (this will be referred to as contraction of substrate hereinafter). Fig. 7 is a graph showing the contraction of substrate #7059 (made by Corning Glass Works) as an example. The abscissa indicates the temperature of a heat treatment and the ordinate the amount of contraction per 10 cm of the substrate. As shown in Fig. 7, a substantial contraction of substrate is caused by a heat treatment at a temperature of 500°C or higher. When a semiconductor such as polycrystalline silicon formed at a comparatively high temperature of 500°C or higher is used as the semiconductor layer 504, a contraction of the substrate after formation of the semiconductor is caused, and hence the pattern displacement of semiconductor layer 504 and gate electrode 506 with respect to source electrodes 503 and drain electrode 502 becomes larger.

This will be described in more detail with reference to Fig. 8.

Source electrodes 801 and a drain electrode 802 are formed and patterned as shown in Fig. 8 prior to forming a semiconductor layer 803. Contraction of substrate is caused while semiconductor layer 803 is formed. Accordingly, the pattern displacement of semiconductor layer 803, gate electrode 804, source line 805 and drain line 806 should be considered with due regard to the contraction of the substrate. A pattern displacement due to an alignment error and a pitch slippage of a photo mask will be referred to as d1 and that due to a contraction of the substrate as d2. The allowable value of the pattern displacement 808 of the semiconductor layer 803 with respect to the source electrodes 801 and the drain electrode 802 is 2d1 + d2 or larger. Further, allowable values of pattern displacements 807, 809, 810 and 811 of gate electrode 804, source line 805, drain line 806 and semiconductor layer 803, respectively, with respect to source electrodes 801 and drain electrode 802 are d1 + d2 or higher. If a pattern displacement in any direction is within these allowable values, the parasitic capacitance is not changed with respect to the case of no pattern displacement. This is effective especially for the case that a semiconductor to be formed at a temperature of 500°C or higher, such as polycrystalline silicon or the like, is used for semiconductor layer 803.

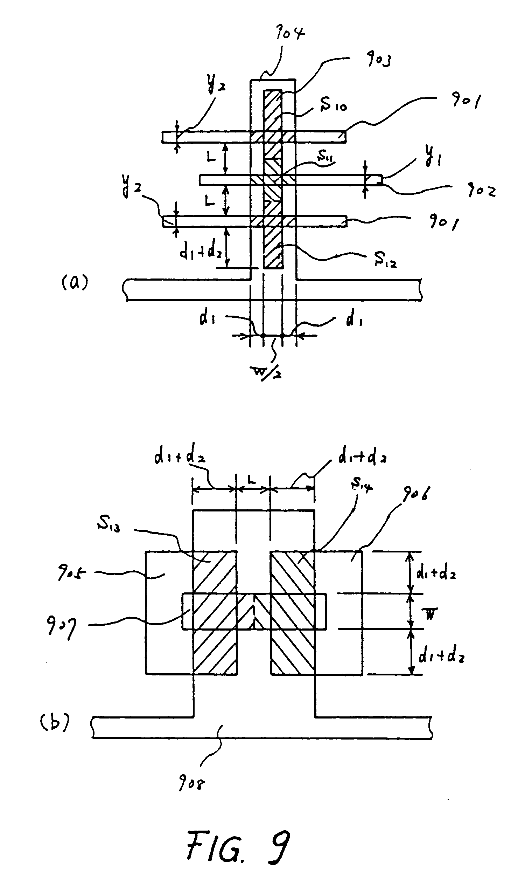

The difference between the parasitic capacitance of the thin film transistor constructed in accordance with the invention and that of a conventional thin film transistor will now be described with reference to Fig. 9. Fig. 9(a) is a top plan view of a thin film transistor constructed in accordance with the invention. The parasitic capacitance between gate electrode 904 and source electrode 901 depends on the areas of the hatched portions S10 and S12. The total area (S10 + S12) is constant even if a pattern displacement occurs in any direction, and this total area is defined by equation (1) as follows:

$$S10 + S12 = \{Y2\ (2d1 + W/2) + W/2 \times L/2 + W/2\ (d1 + d2)\}\ (\mu m^2) \qquad (1)$$

Y2      width of source electrode 901 ($\mu$m)
L      channel length of the thin film transistor ($\mu$m)
W      channel width of the thin film transistor ($\mu$m)

On the other hand, the parasitic capacitance between gate electrode 904 and drain electrode 902 depends on the area of hatched portion S11, and this area is defined by equation (2) as follows:

$$S11 = Y1\ (2d1 + W/2) + 2 \times W/2 \times L/2\ (\mu m^2)- \qquad (2)$$

Y1      width of drain electrode 902 ($\mu$m)

Fig. 9(b) is a top plan view of the conventional thin film transistor. The parasitic capacitance between gate electrode 908 and source electrode 905 depends on the area of hatched portion S13. Likewise, the parasitic capacitance between drain electrode 906 and gate electrode 908 depends on the area of hatched portion S14. In case of no pattern displacement, the area of S13 equals that of S14 and is defined by equation (3) as follows:

$$S13 = S14 = \{2\ (d1 + d2) + W\}\ (d1 + d2) + LW/2\ (\mu m^2) \qquad (3)$$

If the gate insulating films of both types of transistors are made of the same material and have the same thickness, the parasitic capacitances may be regarded as being determined by the areas S10 through S14.

Generally, the pattern displacement d1 due to an alignment error or a pitch slippage of a photo mask is approximately 3 $\mu$m. The contraction of substrate d2 is approximately 6 $\mu$m per 10 cm of the substrate length at about 600°C, as shown in Fig. 7, which is a standard temperature for forming polycrystalline silicon.

Accordingly, if in equations (1), (2) and (3) 3 $\mu$m is substituted for d1 and 0,6X $\mu$m (X is the length in cm of the substrate in the longitudinal direction) is substituted for d2, the following results:

$$S10 + S12 = 2\{Y2\ (6 + W/2) + LW/4 + W/2\ (3 + 0,6X)\}\ (\mu m^2) \qquad (4)$$

$$S11 = Y1\ (6 + W/2) + LW/2\ (\mu m) \qquad (5)$$

$$S13 = S14 = 2\{(3 \times 0,6X) + W\}\ (3 + 0,6X) + LW/2 \qquad (6)$$

In order to reduce the parasitic capacitance effective between the source electrode and the gate electrode of the thin film transistor according to the invention in comparison with that of the conventional thin film transistor, the expression

$$S10 + S12 < S13 \qquad (7)$$

should be satisfied.

Combining equations (4) and (6) with expression (7) reveals

$$Y < 2\ (3 + 0,6X)^2/(12 + W)\ (\mu m) \qquad (8)$$

Thus, it is possible to reduce the parasitic capacitance between the source electrode and the gate electrode in comparison with that of the conventional thin film transistor, when the width Y2 of the source electrode satisfies expression (8).

Fig. 10 illustrates an equivalent circuit of a liquid crystal display device using thin film transistors. For a single source line 1003 there are as many parasitic capacitors 1006 as there are gate lines 1004. However, since according to the invention, the capacitance of the parasitic capacitor 1006 is small, the driving power for a hold circuit 1001 can be reduced, making a small-sized and inexpensive LSI possible. On the other hand, with the same driving power of the hold circuit as with the prior art, a liquid crystal display device with a higher number of gate lines can be driven.

In order to reduce the parasitic capacitance between the drain electrode and the gate electrode in comparison with a conventional thin film transistor, the expression

$$S11 < S14 \qquad (9)$$

should be satisfied. The following expression is obtained by substituting equations (5) and (6) for S11 and S14 in expression (9):

$$Y1 < (6 + 1,2 + W) (3 + 0,6X)/(6 + W/2) \ (\mu m)\text{-} \qquad (10)$$

It is thus possible to reduce the parasitic capacitance between the drain electrode and the gate electrode in comparison with the conventional thin film transistor when the width Y1 of the drain electrode satisfies expression (10).

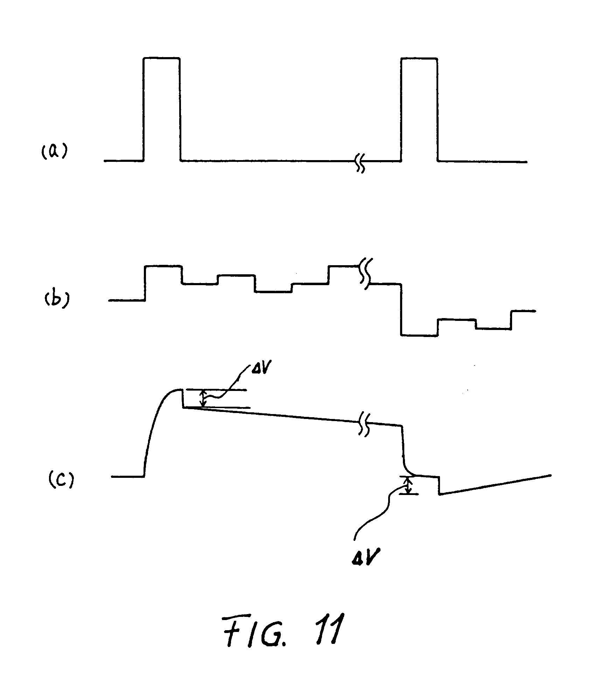

Fig. 11 illustrates general driving waveforms for a liquid crystal display device using thin film transistors. Fig. 11(a) is a gate signal applied to a gate line for rendering the thin film transistors of this line conductive with the transistors of different lines being made conductive on a time sharing basis. The data signal illustrated in Fig. 11(b) is applied to the source line in synchronism with the gate signal and is transmitted to the liquid crystal layer through the thin film transistors. When the thin film transistors of the next line are rendered conductive by the respective gate signal, the thin film transistors of the present line must be rendered nonconductive to isolate the liquid crystal layer from the source line. The data signal stored in the liquid crystal layer has to be held until the next scanning of the present line. Fig. 11(c) illustrates the change of the voltage at the liquid crystal layer of a pixel connected to a thin film transistor. Voltage change $\Delta V$ shown in Fig. 11(c) is caused when the thin film transistor is changed from its ON condition to its OFF condition. $\Delta V$ is determined by the ratio of the parasitic capacitance Cp between the drain electrode and the gate electrode of the thin film transistor to the capacitance Clc of the liquid crystal layer and is expressed as follows:

$$\Delta V \propto Cp \ / \ Cp \ + \ Clc$$

Namely, if the parasitic capacitance Cp is smaller than that of the conventional thin film transistor, $\Delta V$ will be reduced. A reduced $\Delta V$ improves the holding characteristic and allows to achieve a high contrast ratio without flicker which is necessary for achieving a high quality picture. Further, since a variation or dispersion in the parasitic capacitance due to a pattern displacement is substantially avoided even in a large-sized liquid crystal display device, a large-sized liquid crystal display of high picture quality can be realized.

When the thin film transistor according to the invention is employed for an image sensor or a three dimensional integrated circuit, the circuit constant can be brought near to a desired value to achieve high performance.

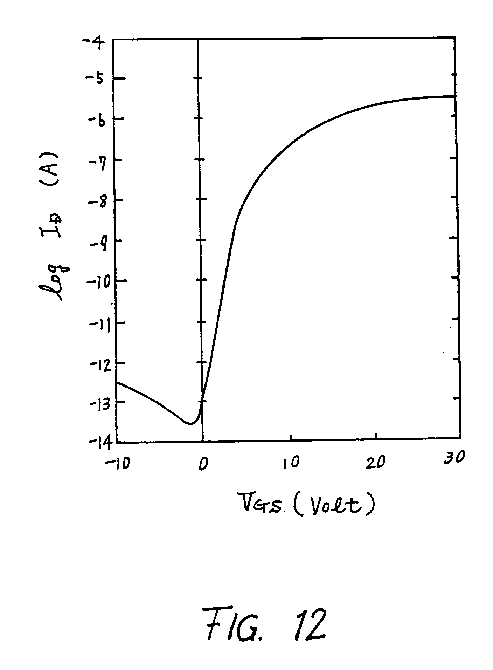

Fig. 12 is a graph showing the electrical characteristics of a thin film transistor constructed in accordance with the present invention. The abscissa shows the gate voltage $V_{GS}$ and the ordinate shows the logarithm of the drain current Id. Drain voltage Vd, channel length and channel width are 4 V, 20 $\mu m$ and 10 $\mu m$, respectively. Polycrystalline silicon having a thickness of 20 nm is used for the semiconductor layer as is clearly shown in Fig. 12, the thin film transistor exhibits a small OFF current and a large ON current and thus, the thin film transistor according to the invention has substantially the same characteristics as the conventional one.

Fig. 13 illustrates an alternative embodiment of the thin film transistor of the present invention. Fig. 13(a) is a top plan view of the thin film transistor according to the second embodiment and Fig. 13-(b) is a cross-sectional view along line C-C' in Fig. 13(a). On an insulating substrate 1301 a source electrode 1303 and a drain electrode 1302 made of a silicon thin film such as polycrystalline silicon or amorphous silicon doped with donor or acceptor type impurities are arranged in parallel with each other. The interval between both electrodes is the channel length L of the transistor and the thickness of the thin film should preferably be between 50 and 500 nm. A semiconductor layer 1304 of a thin film of silicon, such as polycrystalline silicon or amorphous silicon, is formed such as to contact both electrodes 1303 and 1302 on their respective upper side. The thickness of the semiconductor layer 1304 is preferably 200 nm or less. A source line 1308 of a metal or transparent conductive film or the like contacts source electrode 1303 and a drain line 1307 contacts drain electrode 1302. These elements are entirely covered by a gate insulating film 1305 made of $SiO_2$, $SiN_2$, SiON or

the like. Further, semiconductor layer 1304 is entirely covered by a gate electrode 1306 made of metal or a transparent conductive film or the like with the gate insulating film 1305 therebetween. Gate insulating film 1305 also serves as an interlayer insulation film for insulation between wirings.

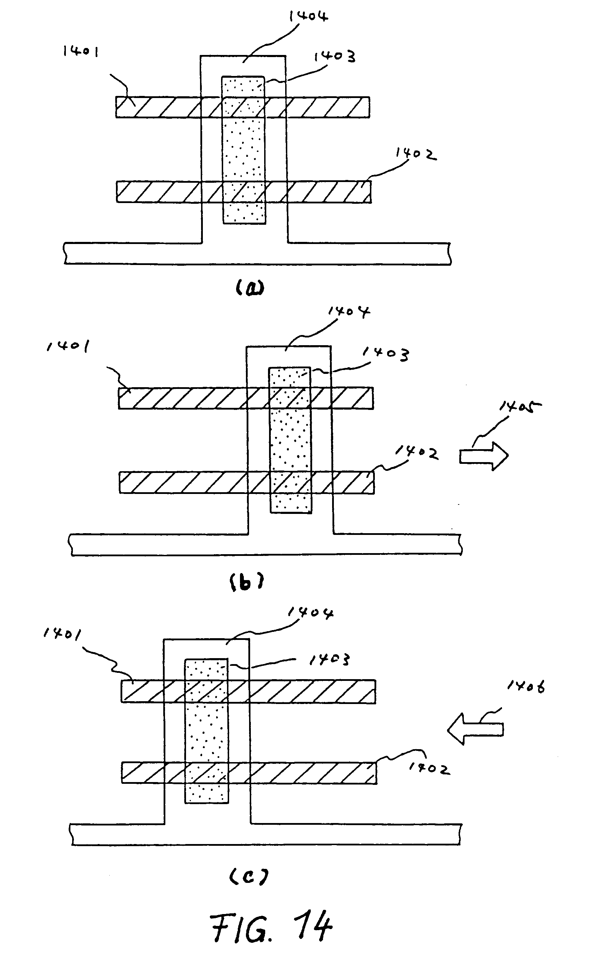

With a thin film transistor constructed as explained above, if a pattern displacement of gate electrode 1404 is caused in the direction of arrow 1405 as shown in Fig. 14(b), the overlapping areas between the gate electrode 1404 on the one hand and the source electrode 1401 and the drain electrode 1402 on the other hand remain constant without any change. Further, if the pattern of the gate electrode 1404 is shifted in the direction of arrow 1406 as shown in Fig. 14(c), the result is the same. Consequently, the parasitic capacitance of the thin film transistor is substantially not influenced by such a pattern displacement.

The embodiment is referred to as a thin film transistor with a staggered structure as shown in Fig. 2(b). It is apparent that a thin film transistor with an inverted-staggered structure (where the gate electrode is disposed below and drain and source above the semiconductor layer) produces the same effect. Furthermore, a thin film transistor with three or more source electrodes produces entirely the same effect.

## Claims

1. A thin film transistor comprising on a substrate (101) a source line (108) extending in a first direction, a source electrode (103) connected to said source line, a drain electrode (102), a semiconductor layer (104) contacting the source and drain electrodes, a gate insulating layer (105) and a gate electrode (106), wherein said source and drain electrodes (103, 102) are formed as parallel elongated strips extending in a second direction substantially perpendicular to said first direction, said semiconductor layer (104) and said gate electrode (106) are formed as elongated strips extending in the first direction, and said gate electrode (106) completely covers said semiconductor layer (104) through the gate insulating film (105), the area of the gate electrode (106) being larger than that of the semiconductor layer (104).

2. The thin film transistor according to claim 1 wherein n source electrodes (103) (n ≥ 2) are provided in parallel with and spaced apart from each other by predetermined spaces, and wherein n-1 drain electrodes (102) are provided in parallel with said source electrodes (103), each drain electrode being arranged at the center portion of a respective one of said spaces between the source electrodes (103).

## Patentansprüche

1. Dünnfilmtransistor, der auf einem Substrat (101) aufweist: eine Source-Leitung (108), die sich in einer ersten Richtung erstreckt, eine Source-Elektrode (103), die mit der Source-Leitung verbunden ist, eine Drain-Elektrode (102), eine Halbleiterschicht (104), die die Source- und die Drain-Elektrode kontaktiert, eine Gate-Isolierschicht (105) und eine Gate-Elektrode (106), wobei die Source- und die Drain-Elektrode (103, 102) als parallele längliche Streifen ausgebildet sind, die sich in einer zweiten Richtung erstrecken, die im wesentlichen rechtwinklig zu der ersten Richtung ist, die Halbleiterschicht (104) und die Gate-Elektrode (106) als längliche Streifen ausgebildet sind, die sich in der ersten Richtung erstrecken, und die Gate-Elektrode (106) die Halbleiterschicht (104) unter Zwischenlage des Gate-Isolierfilms (105) vollständig bedeckt, wobei die Fläche der Gate-Elektrode (106) größer als jene der Halbleiterschicht (104) ist.

2. Dünnfilmtransistor nach Anspruch 1, wobei n Source-Elektroden (103) (n ≥ 2) parallel zueinander und um vorbestimmte Zwischenräume voneinander beabstandet vorgesehen sind, und wobei n - 1 Drain-Elektroden (102) parallel zu den Source-Elektroden (103) vorgesehen sind, wobei jede Drain-Elektrode an dem zentralen Abschnitt eines jeweiligen der Zwischenräume zwischen den Source-Elektroden (103) angeordnet ist.

## Revendications

1. Un transistor à couches minces comprenant, sur un substrat (101), une ligne de source (108) s'étendant dans une première direction, une électrode de source (103) connectée à la ligne de source, une électrode de drain (102), une couche de semiconducteur (104) qui vient en contact avec les électrodes de source et de drain, une couche isolante de grille (105) et une électrode de grille (106), dans lequel des électrodes de source et de drain (103, 102) sont réalisées sous la forme de rubans allongés parallèles qui s'étendent dans une seconde direction pratiquement perpendiculaire à la première direction, la couche de semiconducteur (104) et l'électrode de grille (106) sont réalisées sous la forme de rubans allongés s'étendant dans la première direction, et l'électrode de grille (106) recouvre complètement la couche de semiconducteur (104), avec interposition de la couche isolante de grille (105), l'aire de l'électrode de grille (106) étant supérieure à celle de la couche de semiconducteur (104).

2. Le transistor à couches minces selon la revendication 1, dans lequel n électrodes de source (103) (n $\geq$ 2) sont formées parallèlement les unes aux autres et sont séparées les unes des autres par des espaces prédéterminés, et dans lequel n-1 électrodes de drain (102) sont formées parallèlement aux électrodes de source (103), chaque électrode de drain étant disposée dans la partie centrale de l'un respectif des espaces précités entre les électrodes de source (103).

(a)

(b)

FIG. 1

204

205

202

A                    A'

206  208  203

(a)

204  208  206  203  207  205

202

201

(b)

FIG. 2

10

FIG. 3

FIG. 4

FIG. 5

FIG. 5

FIG. 6

FIG. 7

FIG. 8

FIG. 9

FIG. 10

(a)

(b)

(c)

ΔV

ΔV

FIG. 11

FIG. 12

1307

1308

1303

1304

L

1306

1302

C'

(a)

1306

1305

1307

C'

1302

1304

1303

1301

(b)

FIG. 13

FIG. 14